Europäisches Patentamt

(19) European Patent Office

Office européen des brevets

(11) Publication number : **0 312 824 B1**

# (12) EUROPEAN PATENT SPECIFICATION

(45) Date of publication of patent specification :
**31.08.94 Bulletin 94/35**

(51) Int. Cl.⁵ : **H01L 23/15, H01L 23/498, H01L 21/48**

(21) Application number : **88116354.7**

(22) Date of filing : **03.10.88**

(54) **Ceramic structure with copper based conductors and method for forming such a structure.**

(30) Priority : **19.10.87 US 110246**

(43) Date of publication of application :
**26.04.89 Bulletin 89/17**

(45) Publication of the grant of the patent :
**31.08.94 Bulletin 94/35**

(84) Designated Contracting States :
**DE FR GB**

(56) References cited :
**EP-A- 0 098 067
EP-A- 0 163 548
EP-A- 0 211 619
EP-A- 0 214 916
EP-A- 0 217 176**

(73) Proprietor : **International Business Machines Corporation
Old Orchard Road
Armonk, N.Y. 10504 (US)**

(72) Inventor : **Chance, Dudley Augustus
91 Tauton Hill Road
Newton, CT 06470 (US)**
Inventor : **Hougham, Gareth Geoffrey
Beach Road
Ossining, NY 10562 (US)**
Inventor : **Goland, David Brian
425 Bedford Road
Bedford Hills, NY 10507 (US)**

(74) Representative : **Mönig, Anton, Dipl.-Ing.
IBM Deutschland Informationssysteme GmbH,
Patentwesen und Urheberrecht
D-70548 Stuttgart (DE)**

EP 0 312 824 B1

## Description

The invention relates to ceramic composite structures with copper based conductors and to methods for forming such articles. These articles or structures are useful as circuit substrates on which semiconductor chips, provided with very large scale integrated circuits, are electrically mounted.

Multi-layered ceramic circuit substrates contain patterned metal layers which act as electrical conductors sandwiched between ceramic layers which act as electrical insulators. These ceramic substrates are formed by laminating together thin green sheets of glass particles or an admixture of glass and crystalline particles mixed with binders and patterns of paste containing metal particles mixed with binders for forming conductors between the ceramic greensheet. This green laminate is fired to burn off the binder materials, fired to coalesce the particles to a dense state further fired if necessary to crystallize the densified glass particles or to further crystallize the admixture of glass and crystalline particles to form an insulator and to coalesce the metal particles to form conducting metal lines.

Terms such as ceramic and glass ceramic are often used interchangeably in the art. To avoid confusion for the purpose of this application the following definitions will be used. The term ceramic has the following meaning: an aggregate of randomly oriented crystallites wherein the interstices between crystallites may contain uncrystallized material such as a glass. The terms coalescence or densification refer to a heat treatment to reduce the density of pores in greensheets. The term crystallization refers to further heating after coalescence or densification or heating if there is no coalescence or densification step, to form crystallites from a glass. The term sintering refers to the heat treatment required to form the final ceramic. Sintering of a greensheet of crystallizable glass particles is a heat treatment to coalesce or densify the greensheet plus the heat treatment to form crystallites from the glass. Sintering of a greensheet of an admixture of glass particles and crystalline particles is a heat treatment to coalesce or density the greensheet plus a crystallizing heat treatment only if further crystallization is required. The term sintering temperature means, for a green sheet requiring crystallization, the crystallization temperature. The term sintering temperature means, for a greensheet not requiring crystallization, the coalescence temperature.

Substrates made of ceramics requiring high temperatures for particle coalescence and densification, such as alumina, restrict the choice of co-sinterable conducting metallurgies to high melting point metals, for example refractory metals, such as molybdenum, tungsten, platinum, palladium or a combination of these with each other or certain other metals and precludes the use of good electrical conductors such as gold, silver and copper which have melting points less than the alumina sintering temperature. Alumina is a good insulator, has high thermal conductivity and has good strength. However, it is disadvantageous with respect to its dielectric constant and its thermal coefficients of expansion. The relatively high dielectric constant of alumina, about 10, results in unacceptable electrical signal delays since the pulse propagation speed on the transmission line formed by metal conductors embedded in the dielectric material of the substrate is inversely proportional to the square root of the material dielectric constant. The higher thermal coefficient of expansion of alumina, compared to silicon, results in sheer stress in the solder joints electrically and mechanically connecting device and circuit elements on the chip to the substrate.

Materials often referred to as glass-ceramics have been intensively studied in recent years for use as circuit substrates. These ceramics generally have a low dielectric constant, a low thermal coefficient of expansion which is close in value to silicon and a low sintering temperature. The low sintering temperature permits the use of low melting point metals, such as copper and noble metals, for electrical conductors. Noble metals have low resistivies comparable to copper. However, copper is less expensive and therefore its use substantially reduces manufacturing cost. When copper is used as the electrical conductor, it is necessary that thermoplastic organic binder materials contained within the green sheet used to form the ceramic and contained within the paste used to form the copper conductors be depolymerized and burned out in an atmosphere and at a temperature wherein the copper is not substantially oxidized.

Failure to burn out binders results in less than desirable ceramic properties. For example, if the binder is not fully burned out, residual carbon is left in the sintered ceramic which modifies the ceramic dielectric constant and inhibits complete densification. With only 0.1% residual carbon content the ceramic may be black having an apparent dielectric constant greater than 1000 and, rather than being an insulator the fired ceramic will be a semiconductor.

Removal of the binder is complicated by the additional requirement that the burn-out ambient not oxidize the copper metal lines and planes. If the copper is oxidized, the copper oxide diffuses into the ceramic and changes the dielectric properties of the ceramic. Also, when copper is oxidized it expands causing stress within the green laminate which can result in delamination and cracking of the green laminate. Such cracks may not be removed by the sintering heat treatment there by resulting in a ceramic weakend by cracks.

Two references generally describing binder burn-out and the fabrication of ceramics are U. S. 4,234,367 to Herron et al. and U. S. 4,504,339 to Kamehara et al.

Herron et al. U. S. 4,234,367 describes a method for forming sintered ceramic substrates containing multilevel, interconnected circuit patterns of copper-based concuctor films obtained by heating the green laminate composed ot particles of crystallizable glass in an ambient of hydrogen and water to a burn-out temperature of about 700°C to 800°C at a rate of 1°C to 3°C per minute. A lower burn-out temperature would take a prohibitively excessive amount or time for carbon removal. The binder burn-out time is about 11 hours as is apparent from FIG. 4 of the Herron et al. patent . This long time is needed: 1) to avoid bloating of the ceramic article caused by entrapped volatile products which cause the article to expand instead of contracting on sintering, 2) to fully oxidize carbon in the binders, 3) to avoid drastic volume changes in the copper conductor resulting from the copper-oxide formation, and 4) to maintain reducing to neutral conditions for copper. After the binder is burned out the laminate is sintered in a neutral atmosphere to form the ceramic material by first heating to coalesce the laminate to a dense state and thereafter heating to form crystals from the densified glass particles.

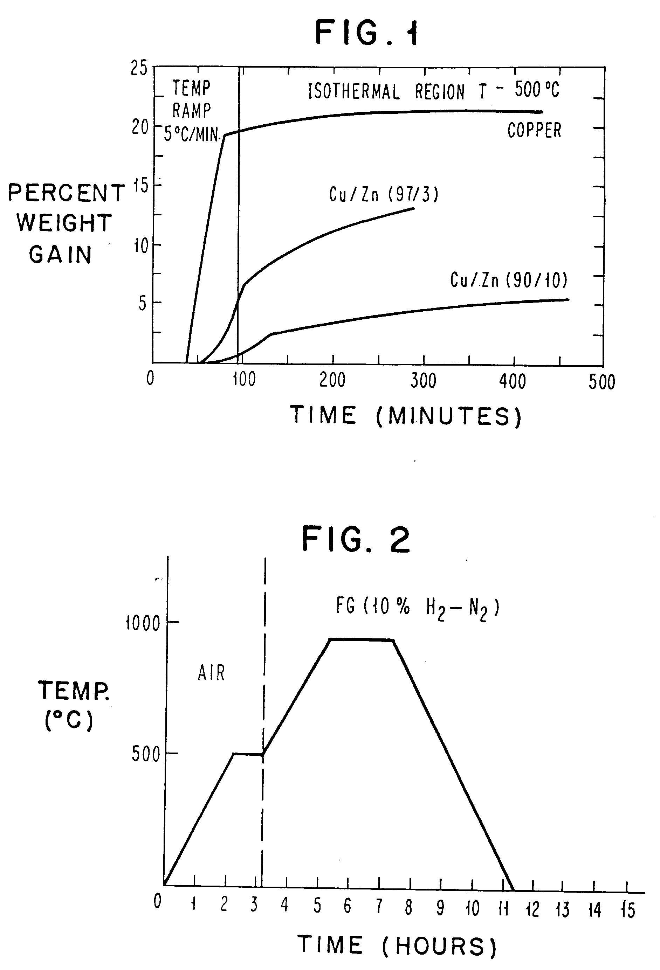

Copending U.S. application Serial Number 929,975 filed November 12, 1986 (equivalent to EP-A-0 267 602) assigned to IBM describes a method for forming sintered ceramic substrates containing multilevel, interconnected circuit patterns of copper-based conductors therein by sintering in a reducing atmosphere after the binders are burned out. U.S. 4,504,339 to Kamehara et al. describes a method for forming sintered ceramic substrates containing multilevel, interconnected circuit patterns of copper-based conductor films from a green laminate composed of an admixture particles of glass and particles of crystallites. Binders are burned-out by firing the substrate in a controlled ambient of an inert atmosphere, e.g. nitrogen, containing water vapor at a partial pressure from 0.0049 to 0.29 bar (0.005 to 0.3 atmospheres) at a temperature between 550°C and 650°C for a time sufficient to burn out the binders in the green laminate and thereafter raising the temperature in an inert atmosphere without water to the sintering temperature to coalesce the green laminate to form the ceramic. The binder burn-out time is about 8 hours as is apparent from FIG. 2 of the Kamehara et al. patent. The burn-out temperature upper bound is limited to 650°C because if the burn-out temperature used were higher, the glass components of the green sheets would begin to coalesce hindering further binder removal.

Both the patent to Kamehara et al. and the patent to Herron et al. teach increasing the burn-out temperature to increase the burn-out rate.

It is an object of the present invention to provide a ceramic substrate with copper based conductors being resistant to oxidation.

It is another object of the invention to provide a ceramic substrate having at least two spaced and electrically interconnected levels of oxidation resistant copper-based electrical conductor patterns.

In the present invention it is also an object to achieve an increased burn-out rate without the necessity of a higher temperature as required by the methods of the prior art.

Providing more rapid binder burn-out is another object of the present invention, as is the provision of binder burn-out in an air atmosphere, rather than in a special atmosphere.

It is another object of the present invention to provide an improved method for producing a multi-layered ceramic structure with patterned copper-based layers as low electrical resistance conductors therein.

It is another object of the present invention to produce a multi-layered ceramic circuit substrate by firing in air a laminated unsintered green composite with copper-based metallurgy contained therein in which organic binder resins can be completely burned out in air without leaving any carbonaceous residue in the ceramic insulator, without substantially oxidizing the copper-based metallurgy and without degrading the ceramic layers.

It is another object of the present invention to produce the improve multi-layered ceramic substrate by burning out binders in air by including an additive to the copper-based metallurgy contained therein.

It is another object of the present invention to provide a method of ceramic fabrication in which the binders can be burned out in air by including additives such as zinc, platinum and chrome to the copper-based metallurgy.

It is another object of the present invention to provide a method of ceramic fabrication in which the binder can be burned out in a time substantially shorter than the obtainable in prior art methods even though very low temperatures are used.

It is another object of the present invention to provide an improved technique for fabricating ceramic structures having conductors embedded therein wherein the dielectric constant of the ceramic is not adversely affected by the fabrication process.

These objects are achieved by an article as disclosed in claim 1 and by a method as disclosed in claim 6.

A method of the present invention preferably forms sintered ceramic substrates containing multilevel, interconnected circuit patterns of copper-based conductor films obtained by first firing in air at a temperature between about 450°C and 600°C to burn-out binders. The binder burn-out time is preferably about 1 to 4 hours in contrast with the very long burn-out time required in the prior art. The binders are more efficiently burned out in an atmosphere of air than in the prior art atmospheres. The temperature is then raised in an inert or reducing atmosphere to the ceramic sintering temperature.

The prior art does not teach or suggest binder burn-out in air. Avoiding the required special atmosphere of the prior art by using air for binder burn-out results in a substantially less complex and less costly process for ceramic circuit substrate fabrication.

By a method of the present invention binders are preferably burned out at a temperature of about 450°C to 600°C which is substantially less than the temperature range of 700°C to 800°C described in the Herron et al. patent. The burn-out temperature of the Kamehara et al. patent is approximately the same as the burn-out temperature of the present invention. However, by a method of the present invention the binder is burned-out in a fraction of the time required by the method of both patents.

While parameters such as temperature, time and atmosphere are important in an improved burn-out process, other considerations must also be observed if the ceramic having metal conductors therein is used as an integrated circuit substrate. These other considerations include the following requirements: first, the embedded conducting lines must have a resistivity which is not greater than the resistivity of a material such as molybdenum which has a resistivity about three times the resistivity of substantially pure copper. The resistivity of molybdenum is marginal for state of the art multi-layered ceramic substrates, especially for high performance applications. Fine lines of molybdenum are too resistive for low loss transmission lines and voltage planes of molybdenum are too resistive for the high currents required in the power distribution system. Second, any oxidation of the embedded conductors must not be great enough to disturb the green laminate. Oxide formation at a conductor surface causes volume expansion of the oxidized material resulting in stress which can cause delamination and cracking of the green laminate. Third, any change in the dielectric constant of the ceramic caused by inter-diffusion of metal oxide in the ceramic must be limited to maintain the dielectric constant to a value less than the dielectric constant of alumina which is about 10.

It has been found, quite unexpectedly, that all these requirements can be met while burning out binders in air by including a selected additive to a copper based metallurgy which forms the conductor pattern within the ceramic substrate. Examples of additives satisfying these requirements are zinc, platinum and chrome. Zinc from between about 3 % to about 25 % by weight is particularly unique in permitting rapid binder burn-out in air.

Known prior art does not teach or suggest including an additive in copper conductors embedded in a ceramic substrate. It is acknowledged that the use of additives for corrosion resistance is taught in the semiconductor art. P. Farrar et al. in "Corrosion Resistant Aluminum-Copper Alloys" IBM Technical Disclosure Bulletin Vol. 13, No. 8, pp. 2125 (Jan. 1971) describes alloys which provide corrosion resistant conductors useful in semiconductor device manufacturing. Small amounts of material are added to aluminum-copper alloys to increase the corrosion resistance of the alloy. Zinc is an example of a material which is added in an amount less than 1 % by weight. This article neither teaches nor suggests alone or in combination with other prior art adding zinc to copper in any amount to avoid oxidation of copper-based conductors during the burn-out of binders in the fabrication of a ceramic substrate containing copper based conductors therein.

The method of the present invention, in its broadest aspect, comprises forming a multi-layer ceramic composite structure with copper-based conductors therein, wherein binders in the green sheets forming the ceramic and in the paste forming the conductors are burned out in air.

The composite structure is formed from at least one green sheet comprised of a thermoplastic organic binder having dispersed within the binder glass particles or an admixture of glass and crystalline particles. The green sheet has a sintering temperature below the melting point of the copper-based metallurgy which forms conductors within the composite structure. On the surface of the green sheet is deposited a pattern of a copper based conductor forming composition. The principal conducting component of this composition is copper.

A second green sheet is superimposed on the surface of the first green sheet sandwiching the metal pattern between the first and second green sheets. A multi-layered structure can have any number of conducting layers and green sheet layers positioned between the conducting layers. The green sheets are laminated together. The laminated green sheets are then heated in an ambient of air to burn-out temperature and maintained thereat for a time sufficient to decompose and eliminate the binders.

The burn-out temperature is not sufficient to cause a substantial change in the state of the green laminate and the copper-based conductors paste therein. An inert or recuding atmosphere is substituted for the air ambient. The laminate is then sintered to form the ceramic structure having at least one layer of copper-based conductors within the interior of the structure. For green sheets of glass particles sinterings includes heating to a temperature sufficient to coalesce the green laminate to a dense state and thereafter heating to crystallize the glass particles into a ceramic composite material. For green sheets of an admixture of glass particles and crystalline particles if no additional crystallization is required sintering is limited to heating to a temperature sufficient to coalesce the green laminate to a dense state to form the ceramic. If additional crystallization is required, the densified laminate is thereafter heated to crystallize glass particles to form the ceramic.

The copper based metallurgy used to form the conductor patterns is a combination of copper with an additive which provides oxidation resistance to metallurgy during the heating of the laminate in air to burn out binders.

The additive is selected to maintain the resistivity of the metallurgy at a value less than about three times the resistivity of copper. The additive limits oxide formation on the conductor pattern to substantially prevent delamination and cracking of the green laminate during binder burn-out and sintering. Also, the dielectric constant of the fully sintered ceramic remains less than about 10.

The copper-based metallurgy can be metal based combinations such as an alloy of copper and the additive, or fine copper particles coated with the additive. Additives useful for practicing the present invention are zinc, platinum and chrome or a combination of these materials. Zinc is particularly effective to provide oxidation resistance to copper-based conductors during binder burn-out in air.

In accordance with a more particular aspect of the present invention, the conductor patterns within the multi-layered ceramic structure are extended to at least one surface of the structure. A semiconductor chip is mounted to this surface in electrical connection to at least a portion of the pattern extensions.

Advantageous embodiments of the article claimed in claim 1 and of the method claimed in claim 6 are disclosed in the subclaims.

These and other objects, features and advantages will be apparent from the following more particular description taken in conjunction with the accompanying drawings.

Fig. 1 is a graph illustrating thermogravimetric results for copper and copper-zinc alloys.

Fig. 2 is a curve showing a firing schedule in accordance with one embodiment of this invention.

It was discovered, in accordance with this invention that binders in green sheets of glass particles or an admixture of glass and crystalline particles used to form a sintered ceramic article and binders in a copper-based paste used to form conductors within the sintered article can be burned out in an ambient of air while maintaining minimal and non-detrimental oxidation of the surface of the copper-based conductors. Copper in combination with additives such as zinc, platinum and chrome are more oxidation resistant main than untreated copper. Such combinations are used to form conductors within ceramic articles by the method of the present invention.

A ceramic composite structure formed by the method of the present invention is useful as a substrate on which a semiconductor chip is mounted to provide electrical connection of device and circuit elements on such semiconductor chip to a support structure, such as a printed circuit board to which the substrate is electrically connected.

The composite structure is formed from at least one green sheet, comprised of a thermoplastic organic binder having dispersed within the binder particles of a crystallizable glass or an admixture of glass particles and crystalline particles. Commonly used ceramic binders are Butvar (registered trademark of Monsanto Inc.), polyvinyl butyral and polyvinyl acetate. Such binders are exemplary only and not limiting. The sintering temperature of the green sheet is less than the melting point of the copper-based metallurgy which forms conductors within the composite structures. The sintering temperature of a green sheet composed of crystallizable glass particles is the crystallization temperature. The sintering temperature of an admixture of glass and crystalline particles is the coalescence temperature if no further crystallization is required or the crystallization temperature if further crystallization is required.

Examples of crystallizable glasses, useful for practicing the present invention, are disclosed in U.S. Patent No. 4,301,324 to Kumar et al. and the process for making such ceramic structure is disclosed in U.S. Patent No. 4,413,061 to Kumar et al. The teachings of both patents are incorporated herein by reference. The disclosed ceramic structures are characterized with low dielectric constants and are compatible with circuitry of copper-based metallurgy co-sinterable therewith. These glasses have crystallization temperature in the range of about 850°C to 970°C.

Of the two types of ceramics disclosed in the aforesaid patent Nos. 4,301,324 and 4,413,061, one has spodumene, $Li_2O \sim AL_2O_3 \sim 4SiO_2$, as the principal crystalline phase while the other has cordierite, $2 MgO$ $2Al_2O_3 5SiO_2$, as the principal crystalline phase. A common feature of these sintered ceramics, among others, is their excellent sinterability and crystallization below 1000°C.

The terms spodumene glass and cordierite glass as used herein refer to the uncoalesced and uncrystallized glass particles. The terms spodumene ceramic and cordierite ceramic as used herein refer to the coalesced and crystallized ceramic.

The multi-layered ceramic of the present invention includes, but is not limited to, the spodumene ceramics and cordierite ceramics as described in the Kumar et al. patents.

Examples of crystalline particles useful to form an admixture of glass and crystalline particles from which a ceramic can be formed are alumina, cordierite, spodumine, quartz, beta-eucryptite and aluminum nitride. These crystallites are exemplary only and not limiting. The glass particles contained in the admixture can be any glass, such as for example borosilicate glass, which will coalesce to a dense state to encapsulate the crystalline particles.

On the surface of the green sheet is deposited a pattern of a copper-based conductor forming composition which includes a copper paste binder, for example ethylcellulose. The principal conducting component of the composition is copper.

A second green sheet is superimposed on the first sheet to sandwich the conductor pattern therebetween. The sheets are laminated together. A multi-layered ceramic structure is formed by laminating green sheets alternately with patterns of copper-based paste between green sheets. Copper patterns separated by glass sheets are connected by through-holes or vias in the green sheets which are filled with the copper-based paste. For a ceramic structure for use as a semiconductor chip substrate, the copper pattern is extended to at least one surface of the composite structure.

The laminated structure is heated to the burn-out temperature in an ambient of air at a rate which does not disturb the integrity of the substrate. If burn-out is too rapid, plasticizers contained in the binder in the green sheets will come off too rapidly causing blisters and resulting in delamination of the green laminate. The laminate is maintained at the burn-out temperature for a sufficient time to decompose and eliminate the binders in the green sheets and copper-based paste. The temperature must not be high enough to melt the copper-based conductor pattern and must not be high enough to cause coalescence of the glass particles. A requirement for binder removal is that the ceramic body remain porous until all residues have been removed. If the glass particles in the green laminate begin to coalesce before the binders are burned-out, the products of the binder decomposition become trapped in the ceramic: 1) leaving carbon residues which increase the ceramic dielectric constant, 2) forming pores in the glass ceramic preventing its complete densification and 3) delaminating the green laminate if the pressure of the trapped products is great enough.

The principal component of the copper based conductor is copper combined with an additive. Any additive which satisfies the following criteria is useful to practice the present invention. The additive is selected to maintain the resistivity of the copper-based metallurgy at a value less than about three times the resistivity of copper, which is about equal to the resistivity of molybdenum. Molybdenum is currently used in alumina multi-layered ceramic substrates and an improved conductor should have a resistivity less than that ot molybdenum. The melting point of the metallurgy must remain greater than the sintering temperature of the green laminate. The additive must either prevent oxide formation at the surface of the metal forming the conductor pattern or limit oxide formation so as 1) not to cause substantial delamination of the green laminate, 2) not to cause cracks in the sintered ceramic and 3) to maintain the dielectric constant of the sintered ceramic less than that of alumina which is about 10.

Examples of additives useful to practice the present invention are zinc, platinum and chrome or a combination of these materials. These are exemplary only and not limiting. The copper-based conductor can be metal combinations such as an alloy of copper with an additive or fine copper particles of about 1 to 5 $\mu$m in size having a thin coating thereon of an additive. It has been found that zinc is a particularly unique additive to permit rapid binder burn-out in air by the method of the present invention.

For a conductor formed from additive coated copper particles, as the temperature is increased during binder burn-out and sintering, the additive combines or alloys with the copper. For zinc coated copper particles mixing begins about 420°C. The permitted range of coating thickness is determined by the copper particle size in such a way that after mixing the criteria of the proceeding paragraph are satisfied. For a sintered copper conductor with a zinc additive, to obtain a conductor resistivity of less than 6 $\mu$m micro-ohm-cms, a zinc content of less than 10 weight percent is required. For a copper particle size of about 2 $\mu$m, a zinc coating of about 88,6 nm thickness is required to obtain a 10 weight percent zinc content.

For convenience, the invention will be further described in terms of combinations of copper and zinc. However, it should be understood that the method is not limited to such combinations.

FIG. 1 shows thermogravimetric results from heating copper-zinc alloy powders in oxygen and heating substantially pure copper in oxygen. The change in weight of samples exposed to oxygen is measured. Sample weight gain is from oxide formation on the sample surface. At a typical binder burn-out heating rate of about 5°C per minute, copper is completely oxidized before 500°C is reached. On the other hand, for zinc alloy powders, the copper is protected from substantial oxidation. For 3% zinc alloy the gain in weight is less than 5% on reaching 500°C and for 10% zinc alloy the gain in weight is less than 5% even after 5 hours at 500°C. On the other hand, the gain in weight of the pure copper is about 20% on reaching 500°C after one and a half hours. Since the copper-zinc alloy weight gain is less than that of pure copper, the alloy is less oxidized. The zinc content of the copper-zinc alloy affects its melting point and resistivity. As the zinc content increases the melting point decreases and the resistivity increases.

The zinc content can be increased to a point such that the copper-zinc alloy does not become molten at the sintering temperature of the green laminate in which the copper-zinc conductors are embedded. For example, for a ceramic substrate having a sintering temperature of about 950°C a copper-zinc alloy having about 25% zinc by weight will not be molten at such a temperature. The zinc content by weight has a lower bound such that the copper zinc conductor is not substantially oxidized during binder burn-out. Greater than about 3% of zinc by weight is generally necessary to satisfy this condition.

The substantially greater increase in weight of the pure copper is believed to occur because as the surface of the copper is oxidized, the resulting copper oxide surface layer cracks because of a substantial volume expansion on forming copper oxide. Such cracks permit oxygen to contact the unoxidized surface of the copper resulting in further oxide formation.

On exposure of a copper-based metallurgy with a zinc additive to an oxidizing atmosphere, such as air, it is believed that the zinc oxidizes to form a coating of zinc oxide, ZnO, on the surface of the conducting metal. The zinc oxide is believed to be more adherent to the surface than copper oxide and less likely to crack. Also, Zinc oxide formation proceeds more rapidly than copper oxide formation since it is thermodynamically more favorable. At the onset of the surface oxide formation, both copper and zinc oxidize to form oxide at the surface. The zinc oxide layer thickness increases more rapidly and substantially reduces the rate of transport of oxygen from the air ambient through the oxide to the unoxidized copper and zinc. This results in a substantial reduction in further thickening of the zinc oxide layer. It is believed that at the onset of the surface oxide formation the less adherent copper oxide diffuses into the ceramic. As the oxidation proceeds, the zinc oxide surface layer substantially limits further copper oxide formation and diffusion into the ceramic. Further heating in a reducing atmosphere of the subsequent step to sinter the green laminate of the green glass, reduces the surface metal oxide and the metal oxide which diffused into the ceramic to the metal state. The metal left in the ceramic increases the ceramic dielectric constant. Thus, the self limiting surface oxide formation prevents substantial change in the ceramic dielectric constant by limiting the extent of oxide diffusion into the ceramic.

Some additives, such as platinum, prevent oxidation of the copper-based conductor surface during binder burn-out. An additive, such as chrome, forms a self limiting surface oxide in a similar fashion to zinc.

Additives, such as zinc, which permit self limiting oxidation of the conductor surface are added at least in an amount which permits no more than about 15% volume increase of the copper-based conductor. Greater volume increase can cause cracks in the unsintered green laminate during binder burned-out. Such cracks generally do not heal on sintering. These cracks substantially reduce the strength of the sintered ceramic.

Structures containing twenty layers of spodumene or cordierite ceramic sheets laminated with metal planes of copper and copper-zinc alloy were burned out in air at 500°C and 600°C for up to six hours. The results indicate that after a temperature ramp of 3.6°C per minute to 500°C the binder is completely burned out after one hour at 500°C. The binder is completely burned-out in about 3.3 hours. On the other hand, substantial disruption of the laminate with copper planes was observed.

If these structures are then heated at a rate of about 1°C to 5°C per minute in a reducing atmosphere, such as forming gas (10% $H_2$-$N_2$) or a neutral atmosphere of nitrogen gas, to the ceramic sintering temperature, e.g. 950°C, and held there for two hours, the ceramic density achieve is about 99% of the theoretically calculated density. During this heating step, as noted above any oxide formed at the conductor surface is reduced. The oxygen is burned off and the metal constituent of the oxide is left in the ceramic increasing its dielectric constant. It is desirable to maintain the dielectric constant of the ceramic at a value less than that of alumina which is about 10. If there is too much surface oxide or if it is reduced to rapidly, the escape of oxygen can cause delamination of the laminated sheets.

Table 1 lists measured electrical resistivities of copper and copper-zinc conductors (by the commonly known four point probe method) and the distance the copper moves into the crystallized ceramic for these structures as a result of copper oxide diffusion.

TABLE I

Properties of Air Burned-off Glass Ceramic/Cu Alloy

| Burn-off Temp Time (°C) (Hr) | Sintering Temp Time (°C) (Hr) | Ceramic Density | Metal | Resistivity Micro ohm-Cm | Cu Diffusion in ceramic (distance) |
|---|---|---|---|---|---|
| 500 1.0 | 960 2.0 | 2.59 | Cu-3% Zn | 4.35 | <2 μm |
| 500 1.0 | 960 2.0 | 2.59 | Cu-10% Zn | 5.40 | <2 μm |
| 500 1.0 | 960 2.0 | 2.59 | Cu | 3.43 | <50.8 μm |

Accordingly, a process has been developed to remove polymeric binders from ceramic/copper-based multi-layered substrates based on this concept. The process involves heating a laminated assembly of green ceramic layers, with an internal copper-based pattern of metal conductors therein in air to burn-out or depolymerize the binder without detrimental oxidation of the conductors. Further heating in a reducing atmosphere returns the oxidized metal to its metal state.

It is the preferred embodiment of the present invention to burn-out the binder in air at a rate of about 1°C to 5°C per minute to a burn-out temperature of from about 450°C to about 600°C at which even a low melting point glass such as borosilicate glass in a glass and crystallite admixture, can be used because it does not coalesce thereat. The laminate is held at this temperature, referred to herein as the hold temperature, for a time sufficient to burn-out the binder. The preferred green sheet forming the laminate contains crystallizable glass particles of cordierite or spodumene glass and the preferred conductor is copper with a zinc additive of

8

from about 3% to about 25% by weight.

If the burn-out temperature is lower than about 450°C the binder resin contained in the green sheet does not satisfactorily burn out. The upper bound of the binder burn-out temperature is set by the ceramic properties. The stacked layers of green sheets must be porous at the binder removal hold temperature to allow complete removal of the binders. If the hold temperature is too high, the glass particles will densify trapping binder residue. Examples of illustrations of ceramics used for the preferred embodiment of this invention are the spodumene and cordierite glass formulations disclosed in the aforesaid patents to Kumar et al. The crystallization temperatures of these ceramics are in the range of about 850°C to about 970°C. In a second firing step the laminated multi-layered glass structure is heated preferably at a rate of about 1°C to 5°C per minute in a reducing or neutral atmosphere to the sintering temperature.

A fired composite structure of laminated multi-layer ceramic layers with metal planes therein for use as a circuit substrate has the metal pattern extended to at least one surface of the fired laminate. An integrated circuit semiconductor chip is mounted on the laminate in electrical connection with the metal extensions.

EXAMPLE

The multi-layered substrate fabrication process involves the following illustrative basic steps.

Step 1

The cullet of the chosen crystallizable glass is a cordierite type glass disclosed in U.S. Patent No. 4,301,324 to Kumar et al. is ground to average particle sizes in the range of 2 to 7 μm The grinding can be done in two steps, a preliminary dry or wet grinding to 400 mesh particle size followed by further grinding with suitable organic binders and solvents until the average particle size is reduced to lie between 2 to 7 μm and a castable slurry or slip is obtained. A single stage prolonged grinding of the cullet in the medium of the binder and solvent, until the desired particles sizes are obtained can be used. In the latter case, a filtering step may be necessary to remove oversized particles.

By way of example, a suitable binder is polyvinylbutyral resin with a plasticizer such as dipropylglycol-dibenzoate (e.g. the commercial Benzoflex plasticizer of the Tennessee Products and Chemical Corp). Other suitable polymers are polyvinyl acetate, selected ones of the acrylic resins, and the like. Similarly other suitable plasticizers such as dioctylphthalate, dibutyl phthalate, and the like, can also be used.

The purpose of adding an easily evaporable solvent is (1) to initially dissolve the binder so as to enable it to coat the individual glass particles, and (2) to adjust the rheology of the slip or slurry for good castability. A particularly effective solvent for the purpose of this example are the dual solvent systems of U.S. Patent No. 4,104,245, specifically the dual methanol/-methyl isobutylketone (in a 5/8 weight ratio) solvent system.

Step 2

The slip or slurry prepared as in Step 1 is cast, in accordance with conventional techniques, into thin green sheets (e.g. about 75 -250 μm (3-10 mils) thick), preferably by doctor-blading techniques.

Step 3

The cast sheets are blanked to the required dimensions and via holes are punched through them in the required configuration.

Step 4

A metallizing paste of copper-zinc alloy containing 5% zinc by weight is extruded or screened into the via holes in the individual sheets.

Step 5

A suitable copper-zinc alloy paste or ink is then screen-printed onto the individual green sheets of Step 4, in the required conductor patterns.

Step 6

A plurality of sheets, prepared as in Step 5, are laminated together in registry in a laminating press;

The temperature and pressure employed for lamination should be such as to cause (1) the individual green sheets to bond to each other to yield a monolithic green substrate, and (2) to cause the green sheet to sufficiently flow and enclose the conductor patterns.

Step 7

Firing of the laminate to the sintering temperatures to accomplish binder removal, densification or coalescence of the glass particles, and conversions to a glass-ceramic by crystallization with concurrent sintering of the metal particles, in the conductor patterns, the dense copper-zinc lines and vias.

A typical firing schedule is shown in FIG. 2. For this example, the green laminate is heated at a rate of $3.6°C/min.$ in air to a hold temperature of 500°C. The laminate is held at this temperature for about one hour. The air ambient is switched to a forming gas (10% $H_2$ - $N_2$) ambient at which point the heating is again elevated at a rate of $3.8°C/min.$ to the crystallization temperature of the glass (e.g. about 960°C for the glass #12), which temperature is held for about 2 hours, after which the temperature is reduced to ambient at a rate of about $3.8°C/min.$

While the invention has been illustrated and described with respect to preferred embodiments, it is to be understood that the invention is not limited to the precise constructions herein disclosed, and the right is reserved to all changes and modifications coming within the scope of the invention as defined in the appended claims.

## Claims

1. An article comprising:
   a ceramic, formed from at least one green sheet, comprised of a thermoplastic binder having dispersed within particles of a crystallizable glass or an admixture of glass particles and crystalline particles; and an oxidation resistant copper-based electrical conductor pattern embedded in said ceramic, said pattern having terminal portions extending to at least one surface of said article for electrical connection thereto, said conductor containing copper and an additive, said additive being present in an amount sufficient to provide oxidation resistance to said conductor during burn-out in an air ambient of said binder present in said article during fabrication thereof to maintain the electrical resistivity of said conductor pattern to a value less than about three times the electrical resistivity of substantially pure copper and to maintain the melting temperature of said conductor pattern to a value greater than the sintering temperature of said ceramic, said oxidation resistance limiting oxide formation to prevent delamination and cracking of the green laminate forming said ceramic during said binder burn-out, and to maintain the dielectric constant of said ceramic to a value less than about 10.

2. Article according to claim 1, wherein said copper based conductor is an alloy of copper and said additive being preferably selected from the group consisting of one or more of zinc, platinum and chrome where in case zinc is used as said additive, the weight percent of zinc being preferably from about 3 % to about 25 %.

3. Article according to claim 1 or 2 further including an integrated circuit semiconductor chip mounted on said surface in electrical connection to a part of said terminal portions for electrical interconnection to said pattern.

4. Article according to any one of claims 1 to 3, wherein said ceramic contains crystallites selected from the group consisting of one or more of spodumene, cordierite, quartz, beta-eurcryptite and aluminum nitride, alumina, lead glass and borosilicate glass.

5. Article according to any one of the preceding claims,
   wherein said conductor pattern consists of at least two spaced and electrically interconnected levels of said oxidation resistant copper-based electrical conductor patterns for electrical connection to an external circuit element.

6. Method for forming a ceramic composite structure with copper based conductors comprising:
forming at least one green sheet comprised of a thermoplastic organic binder having dispersed therein particles selected from the group consisting of particles of a crystallizable glass and an admixture of glass particles and crystalline particles, said green sheet having a sintering temperature below the melting point of said copper based conductors;
forming on a surface of said first green sheet a pattern of a copper based conductor forming composition wherein the principal component of said composition is copper and wherein said composition further contains an additive, said additive being present in an amount sufficient to provide oxidation resistance to said conductor during the subsequent burn-out in an air ambient of said binder to maintain the electrical resistivity of said conductor pattern to a value less than about three times the electrical resistivity of substantially pure copper and to maintain the melting temperature of said conductor pattern to a value greater than the sintering temperature of the ceramic to be formed, said oxidation resistance limiting oxide formation to substantially prevent delamination and cracking of the green laminate forming said ceramic during the subsequent binder burn-out, and to maintain the dielectric constant of the ceramic to be formed to a value less than about 10;
superimposing a second said sheet on said surface of said first sheet to sandwich said pattern therebetween;
laminating said superimposed sheets together;
heating said laminate in an ambient of air to a burn-out temperature and maintaining said laminate thereat for sufficient time to decompose and eliminate said binder; and
sintering said laminate in a reducing or inert atmosphere to form a ceramic structure having said copper based conductors extending within the interior thereof.

7. Method according to claim 6, wherein said oxidation resistant copper based conductor is a combination of copper or a copper alloy with said additive being preferably selected from the group consisting of one or more of zinc, platinum and chrome.

8. Method according to claim 7, wherein said combination consists of a distribution of fine copper particles being coated with a thin layer of said additive and having preferably a particle size from about 1 to about 5 μm and wherein in case the said additive is zinc preferably its thickness is such that the resulting combination contains from between about 3 to about 25 weight percent zinc.

9. Method according to any one of claims 6 to 8, wherein said crystallizable glass is selected from the group consisting of spodumene glass, cordierite glass, lead glass and borosilicate glass, and wherein said admixture contains crystalline particle selected from the group consisting of one or more of alumina, cordierite spodumine, quartz, beta-eucryptite and aluminum nitride.

10. Method according to any one of claims 6 to 9, wherein said laminate is heated preferably at a rate of about 1°C to 5°C per minute to a burn-out temperature in the range of about 450°C to about 600°C and preferably held at the burn-out temperature for less than about 4 hours.

11. A method according to any one of claims 6 to 10 wherein a multilayered structure is formed having layers of patterns of said copper-based conductor forming composition, there being at least between adjacent layers of said patterns green sheets according to claim 6, at least some of said green sheets between said adjacent layers of patterns having through holes of said copper-based conductor forming composition therein for electrically interconnecting said adjacent layers of patterns.

**Patentansprüche**

1. Gegenstand, umfassend
eine Keramik, die aus mindestens einem "green sheet" gebildet wird, das ein thermoplastisches Bindemittel umfaßt, in dem Teilchen eines kristallisierbaren Glases oder eines Gemischs aus Glasteilchen und kristallinen Teilchen feinverteilt sind; und
ein oxidationsbeständiges, auf Kupfer basierendes, elektrisches Leitermuster, das in die Keramik eingebettet ist, wobei das Muster Anschlußteile hat, die sich bis zu mindestens einer Oberfläche des Gegenstands erstrecken, um eine elektrische Verbindung mit ihm zu ermöglichen,
wobei der Leiter Kupfer und einen Zusatzstoff enthält und der Zusatzstoff in einer Menge vorliegt, die

11

ausreicht, um den Leiter während der Zeit, in der das Bindemittel, das in dem Gegenstand während dessen Fertigung enthalten ist, in einer Luftumgebung ausgebrannt wird, oxidationsbeständig zu machen, um den spezifischen elektrischen Widerstand des Leitermusters auf einem Wert zu halten, der niedriger ist als ungefähr der dreifache Wert des spezifischen elektrischen Widerstands von im wesentlichen reinem Kupfer, und um die Schmelztemperatur des Leitermusters auf einem Wert zu halten, der größer als die Sintertemperatur der Keramik ist, wobei die Oxidationsbeständigkeit die Oxidbildung begrenzt, um während des Ausbrennens des Bindemittels eine Delaminierung und Rißbildung beim Grünlaminat, das die Keramik bildet, zu verhindern, und um die Dielektrizitätskonstante der Keramik auf einem Wert zu halten, der niedriger ist als ungefähr 10.

2. Gegenstand gemäß Anspruch 1, bei dem der auf Kupfer basierende Leiter eine Legierung aus Kupfer und dem Zusatzstoff ist, der vorzugsweise aus der Gruppe ausgewählt wird, die aus einem oder mehreren der Stoffe Zink, Platin und Chrom besteht, wobei, wenn Zink als Zusatzstoff verwendet wird, der Masseanteil des Zinks vorzugsweise zwischen ungefähr 3 Masse% und ungefähr 25 Masse-% liegt.

3. Gegenstand gemäß Anspruch 1 oder 2, der darüber hinaus einen Halbleiterchip mit integrierten Schaltkreisen umfaßt, der auf der Oberfläche in elektrischer Verbindung mit einem Teil der Anschlußteile zum Zwecke der elektrischen Verbindung mit dem Muster angebracht ist.

4. Gegenstand gemäß einem oder mehreren der Ansprüche 1 bis 3, bei dem die Keramik Kristallite enthält, die aus der Gruppe ausgewählt wurden, die einen oder mehrere der Stoffe Spodumen, Kordierit, Quarz, β-Eukryptit und Aluminiumnitrid, Aluminiumoxid, Bleiglas und Borsilikatglas umfaßt.

5. Gegenstand gemäß einem oder mehreren der vorangegangenen Ansprüche,
bei dem das Leitermuster aus mindestens zwei voneinander räumlich getrennten und elektrisch miteinander verbundenen Ebenen aus den oxidationsbeständigen, auf Kupfer basierenden elektrischen Leitermustern zur elektrischen Verbindung mit einem externen Schaltungselement besteht.

6. Verfahren zum Bilden einer Keramikverbundstruktur mit auf Kupfer basierenden Leitern, das umfaßt:
die Bildung mindestens eines "green sheet", das ein thermoplastisches organisches Bindemittel enthält, in dem Teilchen feinverteilt sind, die aus der Gruppe ausgewählt wurden, die aus Teilchen eines kristallisierbaren Glases und einem Gemisch aus Glasteilchen und kristallinen Teilchen besteht, wobei das "green sheet" eine Sintertemperatur hat, die unter dem Schmelzpunkt der auf Kupfer basierenden Leiter liegt;
die Bildung eines Musters aus einer Verbindung, die auf Kupfer basierende Leiter bildet, auf einer Oberfläche des ersten "green sheet", wobei der Hauptbestandteil der Verbindung Kupfer ist und die Verbindung darüber hinaus einen Zusatzstoff enthält, wobei der Zusatzstoff in einer Menge aufgebracht wird, die ausreicht, um dem Leiter während des anschließenden Ausbrennens des Bindemittels in einer Luftumgebung Oxidationsbeständigkeit zu verleihen, um den spezifischen elektrischen Widerstand des Leitermusters auf einem Wert zu halten, der niedriger ist als ungefähr der dreifache Wert des spezifischen elektrischen Widerstands des im wesentlichen reinen Kupfers und um die Schmelztemperatur des Leitermusters auf einem Wert zu halten, der größer als die Sintertemperatur der zu erzeugenden Keramik ist, wobei die Oxidationsbeständigkeit die Oxidbildung begrenzt, um eine Delaminierung und Rißbildung beim Grünlaminat, das die Keramik bildet, während des anschließenden Bindemittelausbrennens weitgehend zu verhindern, und um die Dielektrizitätskonstante der zu erzeugenden Keramik auf einem Wert zu halten, der niedriger als ungefähr 10 ist;
das Aufbringen eines zweiten "green sheet" auf die Oberfläche des ersten "green sheet", um das Muster dazwischen einzubetten;
das Zusammenfügen der übereinandergelagerten "sheets", so daß ein Laminat entsteht;
das Erwärmen des Laminats in einer Luftumgebung auf eine Ausbrenntemperatur und das Halten des Laminats auf dieser Temperatur für eine Zeitspanne, die ausreicht, um das Bindemittel zu zersetzen und zu beseitigen; und
das Sintern des Laminats in einer reduzierenden oder inerten Atmosphäre, um eine Keramikstruktur zu bilden, in deren Inneren sich die auf Kupfer basierenden Leiter erstrecken.

7. Verfahren gemäß Anspruch 6, bei dem der oxidationsbeständige, auf Kupfer basierende Leiter eine Verbindung aus Kupfer oder einer Legierung aus Kupfer und dem Zusatzstoff ist, der vorzugsweise aus der Gruppe ausgewählt wird, die einen oder mehrere der Stoffe Zink, Platin und Chrom umfaßt.

**8.** Verfahren gemäß Anspruch 7, bei dem die Verbindung aus feinen verteilten Kupferteilchen besteht, die mit einer dünnen Schicht des Zusatzstoffs überzogen sind und vorzugsweise eine Teilchengröße von ungefähr 1 bis 5 $\mu$m haben und bei dem, wenn es sich bei dem Zusatzstoff um Zink handelt, ihre Dicke vorzugsweise so gewählt wird, daß die sich ergebende Verbindung zwischen ungefähr 3 und ungefähr 25 Masseprozent Zink enthält.

**9.** Verfahren gemäß einem oder mehreren der Ansprüche 6 bis 8, bei dem das kristallisierbare Glas aus der Gruppe ausgewählt wird, die aus Spodumenglas, Kordieritglas, Bleiglas und Borsilikatglas besteht und bei dem das Gemisch kristalline Teilchen enthält, die aus der Gruppe ausgewählt wurden, die aus einem oder mehreren der Stoffe Aluminiumoxid, Kordierit, Spodumen, Quarz, $\beta$-Eukryptit und Aluminiumnitrid besteht.

**10.** Verfahren gemäß einem oder mehreren der Ansprüche 6 bis 9, bei dem das Laminat vorzugsweise mit einer Geschwindigkeit von ungefähr 1 bis 5 °C pro Minute auf eine Ausbrenntemperatur im Bereich von ungefähr 450 °C bis ungefähr 600 °C erwärmt und vorzugsweise für weniger als ungefähr 4 Stunden auf der Ausbrenntemperatur gehalten wird.

**11.** Verfahren gemäß einem oder mehreren der Ansprüche 6 bis 10, bei dem eine mehrschichtige Struktur gebildet wird, die Schichten aus Mustern besitzt, die aus der Verbindung bestehen, die den auf Kupfer basierenden Leiter bildet, wobei mindestens zwischen benachbarten Schichten des Musters "green sheets" gemäß Anspruch 6 liegen und mindestens einige der "green sheets" zwischen den benachbarten Musterschichten Durchgangslöcher besitzen, in denen sich die auf Kupfer basierende, Leiter bildende Verbindung befindet, um die benachbarten Musterschichten elektrisch miteinander zu verbinden.

## Revendications

**1.** Un article comprenant:
- une céramique formée d'au moins une feuille vierge, composée d'un liant thermoplastique dans lequel sont dispersés des particules de verre cristallisable ou un mélange de particules de verre et de particules cristallines, et
- une configuration de conducteur électrique à base de cuivre, résistant à l'oxidation noyée dans ladite céramique, ladite configuration comprenant des bornes qui se prolongent jusqu'à au moins une surface dudit article pour leur connexion à ce dernier,

ledit conducteur contenant du cuivre et un additif, ledit additif étant présent dans une quantité suffisante pour assurer la résistance à l'oxidation dudit conducteur pendant la brûlure en atmosphère ambiante dudit liant présent dans ledit article pendant sa fabrication, afin de maintenir la résistivité électrique de ladite configuration de conducteur à une valeur inférieure à approximativement trois fois la résistivité électrique du cuivre pratiquement pur et de maintenir la température de fusion de ladite configuration de conducteur à une valeur supérieure à la température de frittage de ladite céramique, ladite résistance à l'oxydation limitant la formation d'oxyde afin d'éviter le délaminage et la craquelure de la feuille vierge formant ladite céramique pendant ladite brûlure du liant et afin de maintenir la constante diélectrique de ladite céramique à une valeur inférieure à approximativement 10.

**2.** Un article selon la revendication 1 dans lequel ledit conducteur à base de cuivre est un alliage de cuivre et ledit additif esr de préférence choisi dans le groupe composé d'un ou de plusieurs des matériaux suivants: le zinc, le platine et le chrome, dans lequel au cas où du zinc est utilisé comme ledit additif, le pourcentage en poids de zinc est de préférence de l'ordre de 3% à 25%.

**3.** Un article selon la revendication 1 ou 2 comprenant en outre une microplaquette de semiconducteur à circuits intégrés montée sur ladite surface en connexion électrique avec une partie desdites bornes pour assurer l'interconnexion électrique à ladite configuration.

**4.** Un article selon l'une quelconque des revendications 1 à 3, dans lequel ladite céramique contient des cristallites choisies dans le groupe composé de un ou plusieurs des matériaux suivants: le spodumène, la cordiérite, le quartz, l'eurcryptite-beta et le nitrure d'aluminium, l'alumine, le verre au plomb et le verre au borosilicate.

**5.** Un article selon l'une quelconque des revendications précédentes,

dans lequel ladite configuration de conducteur consiste en au moins deux niveaux espacés et électriquement interconnectés desdites configurations de conducteur électrique à base de cuivre et résistant à l'oxydation pour assurer la connexion électrique à un élément de circuit externe.

6. Un procédé pour former une structure composée de céramique avec des conducteurs à base de cuivre comprenant les étapes suivantes:

- la formation d'au moins une feuille vierge composée d'un liant organique thermoplastique dans lequel sont dispersées des particules choisies dans le groupe composé de particules d'un verre cristallisable et d'un mélange de particules de verre et de particules cristallines, ladite feuille vierge ayant une température de frittage inférieure au point de fusion desdits conducteurs à base de cuivre,
- la formation sur une surface de ladite feuille vierge, d'une configuration d'une composition de formage de conducteur à base de cuivre dans laquelle le composant principal de ladite composition est du cuivre et dans laquelle ladite composition contient en outre un additif,

ledit additif étant présent dans une quantité suffisante pour assurer la résistance à l'oxydation dudit conducteur pendant la brûlure ultérieure en atmosphère ambiante, dudit liant, afin de maintenir la résistivité électrique de ladite configuration de conducteur à une valeur inférieure à approximativement trois fois la résistivité électrique du cuivre pratiquement pur et de maintenir la température de fusion de ladite configuration de conducteur à une valeur supérieure à la température de frittage de la céramique à former, ladite résistance à l'oxydation limitant la formation d'oxyde pour éviter pratiquement le délaminage et la craquelure de la feuille vierge formant ladite céramique pendant la brûlure ultérieure du liant, et afin de maintenir la constante diélectrique de la céramique à former à une valeur inférieure à approximativement 10,

- la superposition d'une dite seconde feuille sur ladite surface de ladite première feuille pour disposer ladite configuration en sandwich entre les deux feuilles,
- le laminage desdites feuilles superposées l'une sur l'autre,
- le chauffage dudit laminé en atmosphère ambiante à une température de brûlage et le maintien dudit laminé à cette température pendant un temps suffisant à la décomposition et à l'élimination dudit liant, et
- le frittage dudit laminé dans une atmosphère réductrice ou inerte pour former une structure en céramique dont lesdits conducteurs à base de cuivre se prolongent à l'intérieur de celle ci.

7. Un procédé selon la revendication 6 dans lequel ledit conducteur à base de cuivre résistant à l'oxydation est une combinaison de cuivre ou d'un alliage de cuivre avec ledit additif qui est de préférence, choisi dans le groupe composé d'un ou de plusieurs des matériaux suivants: le zinc, le platine et le chrome.

8. Un procédé selon la revendication 7 dans lequel ladite combinaison consiste en une distribution de fines particules de cuivre qui sont revêtues d'une mince couche dudit additif, la taille desdites particules étant de préférence de l'ordre de 1 à 5 μm et dans lequel, au cas où ledit additif est du zinc, son épaisseur est de préférence telle que la combinaison obtenue est comprise entre approximativement 3 et 25% en poids de zinc.

9. Un procédé selon l'une quelconque des revendications 6 à 8, dans lequel ledit verre cristallisable est choisi dans le groupe composé du verre au spodumène, du verre à la cordièrite, du verre au plomb et du verre au borosilicate, et dans lequel ledit mélange contient des particules cristallines choisies dans le groupe composé d'un ou plusieurs des matériaux suivants: l'alumine, la spodumine cordièrite, le quartz, l'eurcryptite-beta et le nitrure d'aluminium.

10. Un procédé selon l'une quelconque des revendication 6 à 9, dans lequel ledit laminé est chauffé de préférence à une cadence de l'ordre de 1 à 5°C par minute, à une température de brûlage comprise entre 450°C et 600°C, approximativement, et est de préférence maintenu à la température de brûlage pendant une durée inférieure à 4 heures, approximativement.

11. Un procédé selon l'une quelconque des revendications 6 à 10,

dans lequel une structure multi-couche est formée et présente des couches de configurations de ladite composition de formage de conducteur à base de cuivre, dans laquelle il y a au moins entre les couches adjacentes desdites configurations, des feuilles vierges selon la revendication 6, au moins certaines desdites feuilles vierges entre lesdites couches adjacentes de configurations, comportant des trous de traversée de ladite composition de formage de conducteur à base de cuivre à l'intérieur, afin d'interconnecter électriquement lesdites couches adjacentes de configurations.

14

# FIG. 1

# FIG. 2